# EUROPÄISCHE PATENTSCHRIFT

(11) **EP 3 411 903 B1**
(45) Veröffentlichungstag und Bekanntmachung des Hinweises auf die Patenterteilung: **10.03.2021**
(21) Anmeldenummer: 17702052.6
(22) Anmeldetag: 25.01.2017
(51) Int. Cl.: H01L 23/31, H01L 21/56

(54) **MOLDMODUL, VERFAHREN ZUR HERSTELLUNG EINES MOLDMODULS UND MOLDWERKZEUG FÜR DIE MOLDUMSPRITZUNG EINES MOLDMODULS**
MOLDED MODULE, METHOD FOR PRODUCING A MOLDED MODULE AND MOLD FOR INJECTION MOLDING A MOLDED MODULE
MODULE MOULÉ, PROCÉDÉ DE FABRICATION D'UN MODULE MOULÉ ET MOULE POUR LE SURMOULAGE D'UN MODULE MOULÉ

(30) Priorität: 05.02.2016 DE 102016201800
(43) Veröffentlichungstag der Anmeldung: 12.12.2018
(73) Patentinhaber: Robert Bosch GmbH, 70442 Stuttgart (DE)
(72) Erfinder: MICHELS, Daniel, 72768 Reutlingen (DE); AYDOGMUS, Irfan, 72622 Nuertingen (DE); SUENNER, Thomas, 70178 Stuttgart (DE); KLUTHE, Christian, 70794 Filderstadt (DE); MESSNER, Oliver, 70184 Stuttgart (DE); LEMM, Alexander, 99817 Eisenach (DE); WEHRMANN, Frank, 72770 Reutlingen (DE); KOVACS, Vince, 1191 Budapest (HU)
(86) Internationale Anmeldenummer: PCT/EP2017/051506
(87) Internationale Veröffentlichungsnummer: WO 2017/133941

(56) Entgegenhaltungen:
- DE-T5-112013 004 203
- JP-A- H0 574 999
- JP-A- H0 823 062
- JP-A- S5 984 556
- JP-A- H04 278 573
- JP-A- H05 259 350
- JP-A- H08 139 218
- JP-A- 2003 243 562
- JP-U- S62 104 450

## Beschreibung

Die Erfindung geht aus von einem Moldmodul nach Gattung des unabhängigen Patentanspruchs 1. Gegenstand der vorliegenden Erfindung sind auch ein Verfahren zur Herstellung einer Moldumspritzung eines solchen Moldmoduls und ein Moldwerkzeug für die Moldumspritzung eines solchen Moldmoduls.

Aus dem Stand der Technik ist es bekannt, elektrische Kontakte zwischen unterschiedlichen Baugruppen bzw. Moldmodulen mittels Einpresstechnik massiv parallel herzustellen. Typischerweise wird ein Bauelement in eine flächige Leiterplatte oder bei Leistungsanwendungen in ein flächiges Moldmodul eingepresst, wodurch sich die erforderliche Einpresskraft verteilen kann. In einem für den internen Aufbau vorteilhaften Fall, werden die Außenkontakte seitlich aus dem Moldmodul geführt. Soll zu diesen ein elektrischer Kontakt hergestellt werden, werden die Außenkontakte entweder werkzeugtechnisch oder durch ein Einlegeteil unterstützt, was beides Mehraufwand- bzw. Kosten bedeutet. Das Einlegeteil wird mit sehr geringen mechanischen Toleranzen ausgeführt, damit es keinen Verformungsweg für die Kontakte erlaubt, der zur mechanischen Deformation der Kontakte beim Einpressen führen könnte. Dies verursacht allerdings zusätzliche Mehrkosten. Zusätzlich kann es dabei zur Delamination des Molds vom Außenkontakt kommen, wodurch das Gesamtsystem geschwächt wird. Eine werkzeugtechnische Unterstützung ist bauraumbedingt meistens auch nicht möglich.

Aus der DE 10 2012 204 296 A1 ist eine elektronische Baugruppe mit mindestens zwei Moldmodulen bekannt, welche elektrisch und mechanisch miteinander verbunden sind, wobei jedes Moldmodul zumindest ein elektronisches und/oder elektrisches Bauteil umfasst, welches zumindest teilweise von einer Moldmasse umgeben ist. Hierbei ist mindestens ein Moldmodul als Logikmodul mit mindestens einem aus der Moldmasse herausragenden ersten Kontaktbereich ausgeführt, und mindestens ein weiteres Moldmodul ist als Leistungsmodul ausgeführt, welches mindestens einen aus der Moldmasse herausragenden zweiten Kontaktbereich aufweist. Die elektrische Verbindung zwischen den Moldmodulen ist beispielsweise als Lötverbindung und/oder Schneid-Klemmverbindung und/oder Schweißverbindung ausgeführt.

Aus der US 5,498,902 A DE sind zwei verpackte elektrische Baugruppen bekannt, welche derart miteinander kontaktiert sind, dass Anschlusspins einer ersten elektrischen Baugruppe durch in die Verpackung einer zweiten elektrischen Baugruppe ausgebildete durchgängige Aussparungen geführt sind und dabei mit einer Einpressöffnung eines Einpresskontaktes der zweiten elektrischen Baugruppe kontaktiert sind.

Aus der JP H08 139218 A sind Verfahren und ein Werkzeug zur Herstellung einer Moldumspritzung eines Moldmoduls bekannt.

Aus der JP H08 023062 A und der DE 11 2013 004 203 T5 sind jeweils ein Verfahren und ein Werkzeug zur Herstellung einer Moldumspritzung eines Moldmoduls bekannt, wobei das Werkzeug erste und zweite Teilwerkzeuge aufweist. Zudem offenbart die JP H08 23062 A einen Überprägungsoffset im Übergangsbereich zwischen Kontaktfläche und Moldmasse.

Aus den Druckschriften JP S62 104450 U3 und JP 2003 243562 A sind ebenfalls Moldmodule mit mindestens einem elektronischen Bauteil und mindestens einem Einpresskontakt bekannt, welche von Moldmasse umgeben sind. Der mindestens eine Einpresskontakt weist einen Kontaktierungsbereich mit einer von beiden Oberflächen zugänglichen Einpressöffnung auf, wobei die Moldmasse im Bereich des mindestens einen Einpresskontaktes abgesetzt ist und auf beiden Oberflächen des Einpresskontaktes jeweils einen Moldkragen ausbildet, welcher den Einpresskontakt vollständig umschließt und bei der Kontaktierung auftretenden Einpresskräfte aufnimmt und oberhalb und unterhalb der korrespondierenden Einpressöffnung jeweils einen Raum freilässt.

Aus der gattungsbildenden JP H05 259350 A ist ein Moldmodul mit mindestens einem elektronischen Bauteil und mindestens einem Einpresskontakt bekannt, welche von Moldmasse umgeben sind. Der mindestens eine Einpresskontakt weist einen Kontaktierungsbereich mit einer von beiden Oberflächen zugänglichen Einpressöffnung auf, wobei die Moldmasse im Bereich des mindestens einen Einpresskontaktes abgesetzt ist und auf beiden Oberflächen des Einpresskontaktes jeweils einen Moldkragen ausbildet, welcher den Einpresskontakt vollständig umschließt und bei der Kontaktierung auftretenden Einpresskräfte aufnimmt und oberhalb und unterhalb der korrespondierenden Einpressöffnung jeweils einen Raum freilässt.

### Offenbarung der Erfindung

Das Moldmodul mit den Merkmalen des unabhängigen Patentanspruchs 1 sowie das Verfahren zur Herstellung einer Moldumspritzung eines Moldmoduls mit den Merkmalen des unabhängigen Patentanspruchs 4 und das Moldwerkzeug für die Moldumspritzung eines Moldmoduls mit den Merkmalen des unabhängigen Patentanspruchs 6 haben den Vorteil, dass die Einpresskontaktierung von seitlich aus dem Moldmodul geführten Kontakten ohne Mehraufwand großserientauglich und kostengünstig realisiert werden kann. Ausführungsformen der Erfindung beschreiben hierbei ein Gesamtkonzept aus Moldmodul, Verfahren zur Herstellung einer Moldumspritzung des Moldmoduls und zugehöriges Moldwerkzeug und haben selbst bei großen Stückzahlen keinen negativen Effekt auf die Standzeit des Moldwerkzeugs und ermöglichen eine hohe Fertigungs- und Prozesssicherheit des Moldprozesses. Zudem ermöglichen die Einpresskontakte eine hohe Positionsgenauigkeit und Oberflächengüte der elektrischen Kontaktierung im Moldmodul und eine toleranzlose Unterstützung der Einpresszone zur Vermeidung einer Kontaktverformung.

Das mindestens eine elektronische und/oder elektrische Bauteil wird samt Signalschienen, welche vorzugsweise als Stanzgitter ausgeführt sind, mit einer Moldmasse umschlossen. Durch den Moldschritt wird ein im Moldmodul integrierter Einpresskontakt zur Verfügung gestellt, welcher einerseits von oben kontaktiert und gleichzeitig vollständig mechanisch von der Moldmasse in Form des Moldkragens im späteren Kontaktierungs- bzw. Fügeprozess unterstützt werden kann.

Ein Einlegeteil als Fügehilfe oder eine Unterstützung durch ein zusätzliches Werkzeug sind daher in vorteilhafter Weise nicht mehr erforderlich. Die Kontakte und die für die Einpresstechnik erforderlichen Öffnungen sind dadurch von oben und unten zu erreichen, so dass Einpresskontakte von oben bzw. unten eingefügt werden können und der Pin durch das Loch durchgesteckt werden kann. Durch den Freiraum auf der gegenüberliegenden Seite der Einpressöffnung zum Durchstecken des Pins wird in vorteilhafter Weise die konventionelle Einpresstechnik einschließlich zugehöriger Kraftüberwachung ermöglicht. Die Fügekräfte der konventionellen Einpresstechnik liegen typischerweise im Bereich von 30-120N. Die Fügekraft wird dabei durch den seitlichen Moldkragen aufgenommen, welcher neben den Einpresszonen angeordnet ist. Typischerweise können die ummoldeten Einpresskontakte eine bis zu sechsfach höhere Kraft aufnehmen als die herkömmlichen Einpresskontakte ohne Ummoldung, so dass es bei Ausführungsformen der vorliegenden Erfindung nicht zur Delamination der Moldmasse oder zur plastischen Verformung des Einpresskontaktes kommt. Damit ersetzt der Moldkragen die Funktion der Fügehilfe ohne die mit dieser Lösung verbundenen Zusatzkosten und die mit Dickentoleranzen der Fügehilfe verbundenen nachteiligen Fügetoleranzen aufzuweisen.

Ausführungsformen der vorliegenden Erfindung stellen ein Moldmodul mit mindestens einem elektronischen und/oder elektrischen Bauteil, welches von einer Moldmasse umgeben ist, und mindestens einem am Modulrand angeordneter und seitlich aus dem Moldmodul (1) herausgeführten Einpresskontakt zur Verfügung, welcher einen Kontaktierungsbereich mit einer von beiden Oberflächen zugänglichen Einpressöffnung aufweist. Hierbei ist die Moldmasse im Bereich des mindestens einen Einpresskontaktes abgesetzt und bildet auf beiden Oberflächen des Einpresskontaktes jeweils einen Moldkragen aus, welcher den korrespondierenden Einpresskontakt bereichsweise umschließt und bei der Kontaktierung auftretende Einpresskräfte aufnimmt und oberhalb und unterhalb der korrespondierende Einpressöffnung jeweils einen Raum freilässt. Des Weiteren weist der Einpresskontakt auf beiden Oberflächen um die Einpressöffnung eine Verprägungszone auf, welche den Kontaktierungsbereich von der Moldmasse trennt. Hierbei weist die jeweilige Verprägungszone ein Überprägungsoffset auf, welches 1 bis 5% der Dicke des Einpresskontaktes ausmacht. Durch dieses systematische Überprägungsoffset können trotz Werkzeug- und Einpresskontakttoleranzen die elektrische Kontaktierbarkeit sichergestellt und Moldflash im Kontaktierungsbereich sowie Nacharbeit sicher vermieden werden. Zudem tritt durch den angegebenen Überprägungsoffsetbereich keine nennenswerte Versetzungshärtung des Einpresskontaktmaterials auf, so dass sich keine Probleme für die Zuverlässigkeit der späteren Einpresstechnikverbindung ergeben können. Dies erlaubt in vorteilhafter Weise die großserientechnische Nutzung des Verfahrens.

Zudem wird ein Verfahren zur Herstellung einer Moldumspritzung eines Moldmoduls nach zumindest einem der Ansprüche 1 bis 3 vorgeschlagen.

Hierbei werden vor einem Moldvorgang von oben ein erstes Teilwerkzeug mit einer umlaufenden ersten Verprägungsschneide und von unten ein zweites Teilwerkzeug mit einer umlaufenden zweiten Verprägungsschneide auf den Oberflächen des mindestens einen Einpresskontakts aufgesetzt und durch eine Relativbewegung der beiden Verprägungsschneiden zueinander wird auf beiden Oberflächen eine Verprägungszone mit einem vorgegebenen Uberprägungsoffset erzeugt, welcher 1 bis 5% der Dicke des Einpresskontaktes (20) ausmacht, wobei das erste und zweite Teilwerkzeug während des Moldvorgangs in der Überprägungsposition verbleiben und den Kontaktierungsbereich und den Raum oberhalb und unterhalb der Einpressöffnung von Moldmasse freihalten, wobei die beiden Verprägungsschneiden jeweils eine Fläche einschließen, welche dem Kontaktierungsbereich des Einpresskontaktes entspricht.

Des Weiteren wird ein Moldwerkzeug für die Moldumspritzung eines Moldmoduls vorgeschlagen, welches nach zumindest einem der Ansprüche 1 bis 3 ausgeführt ist.

Das Moldwerkzeug umfasst eine Kavität zur Aufnahme des zu umspritzenden elektronischen und/oder elektrischen Bauteils und des mindestens einen am Modulrand angeordneten Einpresskontakts. Hierbei ist ein erstes Teilwerkzeug als Abdichtstempel mit einer umlaufenden ersten Verprägungsschneide ausgeführt ist, und ein zweites Teilwerkzeug ist als Abdichtstempel mit einer umlaufenden zweiten Verprägungsschneide ausgeführt, wobei die beiden Teilwerkzeuge relativbeweglich zueinander gelagert sind, wobei die Verprägungsschneiden einander gegenüberliegend angeordnet sind. Hierbei schließen die Verprägungsschneiden der Teilwerkzeuge jeweils eine Fläche ein, welche dem Kontaktierungsbereich des mindestens einen Einpresskontakts entspricht. Des Weiteren können die beiden Teilwerkzeuge bis zur Höhe der Verprägungsschneiden aufeinander zubewegbar ausgeführt werden.

Die Form des umgebenden Moldgehäuses wird durch die Form der Kavität in im Moldwerkzeug bestimmt. Diese Kavität und die beiden Abdichtstempel sind in vorteilhafter Weise so ausgestaltet, dass die Einpresskontakte teilweise von einem Moldkragen umschlossen werden.

Ausführungsformen der vorliegenden Erfindung ermöglichen während des Moldvorgangs einen deutlich kleineren Dichtbereich als bei herkömmlichen Lösungen, wodurch mehr Kontakte auf eine vorgegebene Länge integriert werden können. Dieser Vorteil wird insbesondere durch die im Moldwerkzeug integrierten Verprägungsschneiden realisiert, welche die zusätzlichen Verprägungszonen um das Einpressloch erzeugen und somit zuverlässiger abdichten als dies bei den herkömmlichen Lösungen der Fall ist. In vorteilhafter Weise erlauben Ausführungsformen der vorliegenden Erfindung die Verwendung von handelsüblichen Moldmaschinen, die über einfache Auf-/Zu-Teilwerkzeuge verfügen, also insbesondere nicht über die Möglichkeit der gesonderten Ansteuerung von beweglichen Stiften wie dies für herkömmliche Lösungen erforderlich ist.

Zudem erlaubt die vorgeschlagene Realisierung, dass erhöhte mechanische Dickentoleranzen der Signalschienen im Bereich von 10-100µm ausgeglichen werden können, da die beiden Teilwerkzeuge bis zur Schneidenhöhe zusammenfahren können.

Durch die in den abhängigen Ansprüchen aufgeführten Maßnahmen und Weiterbildungen sind vorteilhafte Verbesserungen des im unabhängigen Patentanspruch 1 angegebenen Moldmoduls, des im unabhängigen Patentanspruch 4 angegebenen Verfahren zur Herstellung einer Moldumspritzung eines Moldmoduls und des im unabhängigen Patentanspruch 6 angegebenen Moldwerkzeugs für die Moldumspritzung eines Moldmoduls möglich.

In vorteilhafter Ausgestaltung des Moldmodul kann der mindestens eine Einpresskontakt als Signalschiene eines Stanzgitters ausgebildet werden. Dies ermöglicht eine besonders kostengünstige und einfache Herstellung der Moldmodule. Zudem kann die Signalschiene einen Innenkontakt des mindestens einen elektronischen und/oder elektrischen Bauteils mit einem korrespondierenden als Einpresskontakt ausgeführten Außenkontakt verbinden. Die Einpresskontakte bzw. Signalschienen bestehen vorzugsweise aus einem Kupferblech, welches beispielsweise über einen Stanzprozess hergestellt werden kann. Die Signalschienen können hinter dem Kontaktierungsbereich in Richtung Innenkontakt entweder gerade oder auch gebogen in das Modul geführt und direkt mit dem Innenkontakt verlötet werden oder mittels eines Bonddrahts mit dem Innenkontakt kontaktiert werden.

In vorteilhafter Ausgestaltung des Verfahrens können die Teilwerkzeuge nach dem Aushärtungsvorgang der Moldmasse wieder vom Einpresskontakt abgehoben werden, so dass das Moldmodul aus dem Moldwerkzeug entnommen werden kann.

In weiterer vorteilhafter Ausgestaltung des Verfahrens kann die Relativbewegung der beiden Teilwerkzeuge so vorgegeben werden, dass der Überprägungsoffset einen Wert im Bereich von 1 bis 5% der Dicke des Einpresskontaktes aufweist.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische perspektivische Darstellung eines Abschnitts eines Ausführungsbeispiels eines erfindungsgemäßen Moldmoduls.
Fig. 2 zeigt eine schematische Schnittdarstellung entlang der Schnittlinie II - II in Fig. 1.
Fig. 3 zeigt eine perspektivische Darstellung des Abschnitts des erfindungsgemäßen Moldmoduls aus Fig. 1 mit transparenter Moldmasse.
Fig. 4 zeigt eine schematische Schnittdarstellung eines Ausschnitts eines Ausführungsbeispiels eines erfindungsgemäßen Moldwerkzeugs für die Moldumspritzung des Moldmoduls aus Fig. 1 bis 3.

### Ausführungsformen der Erfindung

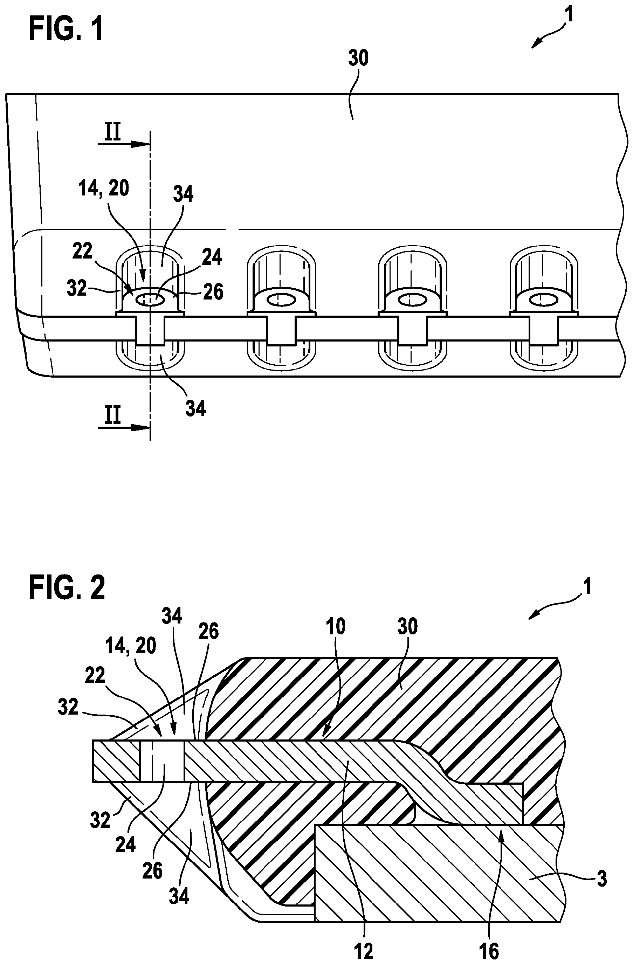

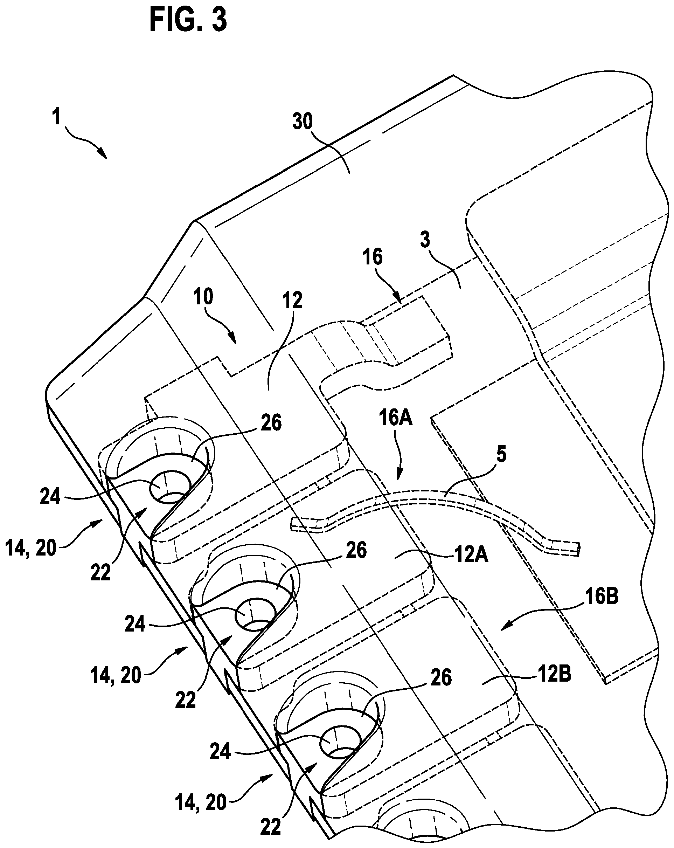

Wie aus Fig. 1 bis 4 ersichtlich ist, umfasst das dargestellte Ausführungsbeispiel eines Moldmoduls 1 mindestens ein elektronisches und/oder elektrisches Bauteil 3, welches von einer Moldmasse 30 umgeben ist, und mindestens einen am Modulrand angeordneten Einpresskontakt 20, welcher einen Kontaktierungsbereich 22 mit einer von beiden Oberflächen zugänglichen Einpressöffnung 24 aufweist. Hierbei ist die Moldmasse 30 im Bereich des mindestens einen Einpresskontaktes 20 abgesetzt und bildet auf beiden Oberflächen des Einpresskontaktes 20 jeweils einen Moldkragen 32 aus, welcher den korrespondierenden Einpresskontakt 20 bereichsweise umschließt und bei der Kontaktierung auftretende Einpresskräfte aufnimmt und oberhalb und unterhalb der korrespondierende Einpressöffnung 24 jeweils einen Raum 34 freilässt. Zudem weist der Einpresskontakt 20 auf beiden Oberflächen um die Einpressöffnung 24 eine Verprägungszone 26 auf, welche den Kontaktierungsbereich 22 von der Moldmasse 30 trennt.

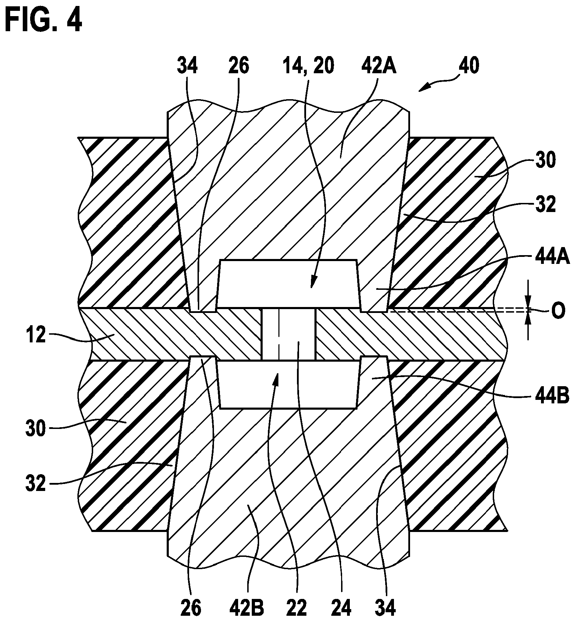

Wie insbesondere aus Fig. 4 ersichtlich ist, weist die jeweilige Verprägungszone 26 einen Überprägungsoffset O auf, welcher 1 bis 5% der Dicke des Einpresskontaktes 20 ausmacht. Im dargestellten Ausführungsbeispiel weist der Einpresskontakt 20 beispielhaft eine Dicke von 1mm auf, so dass der Überprägungsoffset O einen Wert zwischen 10 und 50µm aufweist. Diese systematische Überprägungsoffset O ermöglicht trotz Werkzeug- und Einpresskontakttoleranzen eine gute elektrische Kontaktierbarkeit und vermeidet Moldflash im Kontaktierungsbereich 22 und Nacharbeit. Die Stauchung des Einpresskontaktes 20 mit dem vorgegebenen Überprägungsoffset O tritt in vorteilhafte Weise keine nennenswerte Versetzungshärtung des Materials auf.

Die Einpresskontakte 20 sind im dargestellten Ausführungsbeispiel als Signalschienen 12, 12A, 12B eines Stanzgitters 10 aus Kupferblech ausgebildet. Die Einpresskontakte 20 weisen typischer Weise eine Dicke im Bereich von. 0,5 bis 2mm und eine Breiten im Bereich von 0,5 bis 3mm auf. Zudem verbinden die Signalschienen 12, 12A, 12B jeweils einen Innenkontakt 16, 16A, 16B des mindestens einen elektronischen und/oder elektrischen Bauteils 3 mit einem korrespondierenden als Einpresskontakt 20 ausgeführten Außenkontakt 14. Die Signalschienen 12, 12A, 12B können hinter dem Kontaktierungsbereich 22 in Richtung Innenkontakt 16, 16A, 16B entweder gerade oder auch gebogen in das Modul 1 geführt und direkt mit dem Innenkontakt 16, 16B verlötet werden oder mittels eines Bonddrahts 5 mit dem Innenkontakt 16A kontaktiert werden.

Wie aus Fig. 4 weiter ersichtlich ist, umfasst ein Moldwerkzeug 40 für die Moldumspritzung eines Moldmoduls 1, eine nicht näher bezeichnete Kavität zur Aufnahme des zu umspritzenden elektronischen und/oder elektrischen Bauteils 3 und des mindestens einen am Modulrand angeordneten Einpresskontakts 20. Hierbei ist ein erstes Teilwerkzeug 42A als Abdichtstempel mit einer umlaufenden ersten Verprägungsschneide 44A ausgeführt, und ein zweites Teilwerkzeug 42B ist als Abdichtstempel mit einer umlaufenden zweiten Verprägungsschneide 44B ausgeführt. Die beiden Teilwerkzeuge 42A, 42B sind relativbeweglich zueinander gelagert, wobei die Verprägungsschneiden 44A, 44B einander gegenüberliegend angeordnet sind.

Im dargestellten Ausführungsbeispiel schließen die Verprägungsschneiden 44A, 44B der Teilwerkzeuge 42A, 42B jeweils eine Fläche ein, welche dem Kontaktierungsbereich 22 des mindestens einen Einpresskontakts 20 entspricht. Zudem sind die beiden Teilwerkzeuge 42A, 42B so ausgeführt, dass sie bis zur Höhe der Verprägungsschneiden 44A, 44B aufeinander zubewegt werden können.

Die Teilwerkzeuge 42A, 42B sind Teil einer handelsüblichen Moldmaschinen und als Auf-/Zu-Teilwerkzeug ausgebildet.

Zur Herstellung einer Moldumspritzung des Moldmoduls 1 werden vor einem Moldvorgang von oben das erste Teilwerkzeug 42A mit der umlaufenden ersten Verprägungsschneide 44A und von unten das zweite Teilwerkzeug 42B mit der umlaufenden zweiten Verprägungsschneide 44B auf den Oberflächen des mindestens einen Einpresskontakts 20 aufgesetzt. Durch eine Relativbewegung der beiden Verprägungsschneiden 42A, 42B zueinander wird auf beiden Oberflächen eine Verprägungszone 26 mit einem vorgegebenen Überprägungsoffset O erzeugt, wobei das erste und zweite Teilwerkzeug 42A, 42B während des Moldvorgangs, in welchem flüssige Moldmasse 30 in die Kavität eingeleitet wird, in der Überprägungsposition verbleiben und den Kontaktierungsbereich 22 und den Raum 34 oberhalb und unterhalb der Einpressöffnung 24 von Moldmasse 30 freihalten. Die Teilwerkzeuge 42A, 42B werden nach dem Aushärtungsvorgang der Moldmasse 30 wieder vom Einpresskontakt 20 abgehoben. Zudem ist die Relativbewegung der beiden Teilwerkzeuge 42A, 42B so vorgegeben, dass der Überprägungsoffset O einen Wert im Bereich von 1 bis 5% der Dicke des Einpresskontaktes 20 aufweist. Nach Abschluss des Moldverfahrens ist das elektronische und/oder elektrische Bauteil 3 samt den Signalschienen 12, 12A, 12B aus Stanzgittern mit Moldmasse 30 umschlossen. Durch das Moldverfahren wird mindestens ein im Moldmodul 1 integrierter Einpresskontakt 20 sichergestellt, welcher einerseits von oben bzw. unten kontaktiert werden kann und gleichzeitig im späteren Einpresskontaktierungsprozess vollständig mechanisch von der als Moldkragen 32 ausgeformten Moldmasse 30 unterstützt wird.

Ausführungsformen der vorliegenden Erfindung stellen ein Moldmodul zur Verfügung, dessen Kontaktierungsbereiche einen kleinen Abstand zueinander aufweisen, um möglichst viele Einpresskontakte auf einer vorgegebenen Länge unterzubringen und den vorhandenen Bauraum optimal ausnützen zu können. Zudem halten benachbarte Kontaktierungsbereiche durch die ausgebildeten Moldkragen und deren elektrisch isolierenden Eigenschaften ausreichende Kriech- und Isolationsabstände ein.

## Patentansprüche

1. Moldmodul (1) mit mindestens einem elektronischen und/oder elektrischen Bauteil (3), welches von einer Moldmasse (30) umgeben ist, und mindestens einem am Modulrand angeordneten und seitlich aus dem Moldmodul (1) herausgeführten Einpresskontakt (20), welcher einen elektrischen Kontaktierungsbereich (22) mit einer von beiden Oberflächen zugänglichen Einpressöffnung (24) aufweist, wobei die Moldmasse (30) im Bereich des mindestens einen Einpresskontaktes (20) abgesetzt ist und auf beiden Oberflächen des Einpresskontaktes (20) jeweils einen Moldkragen (32) ausbildet, welcher den korrespondierenden Einpresskontakt (20) umschließt und bei der Kontaktierung auftretende Einpresskräfte aufnimmt und oberhalb und unterhalb der korrespondierende Einpressöffnung (24) jeweils einen Raum (34) freilässt, wobei der Einpresskontakt (20) auf beiden Oberflächen um die Einpressöffnung (24) eine Verprägungszone (26) aufweist, welche den elektrischen Kontaktierungsbereich (22) von der Moldmasse (30) trennt und einen Überprägungsoffset (O) aufweist, welcher 1 bis 5% der Dicke des Einpresskontaktes (20) ausmacht.

2. Moldmodul nach Anspruch 1, **dadurch gekennzeichnet, dass** der mindestens eine Einpresskontakt (20) als Signalschiene (12, 12A, 12B) eines Stanzgitters (10) ausgebildet ist.

3. Moldmodul nach Anspruch 2, **dadurch gekennzeichnet, dass** die Signalschiene (12, 12A, 12B) einen Innenkontakt des mindestens einen elektronischen und/oder elektrischen Bauteils (3) mit einem korrespondierenden als Einpresskontakt (20) ausgeführten Außenkontakt (14) verbindet.

4. Verfahren zur Herstellung einer Moldumspritzung eines Moldmoduls (1), welches nach zumindest einem der Ansprüche 1 bis 3 ausgeführt ist, wobei vor einem Moldvorgang von oben ein erstes Teilwerkzeug (40A) mit einer umlaufenden ersten Verprägungsschneide (42A) und von unten ein zweites Teilwerkzeug (40B) mit einer umlaufenden zweiten Verprägungsschneide (42B) auf den Oberflächen des mindestens einen Einpresskontakts (20) aufgesetzt werden und durch eine Relativbewegung der beiden Verprägungsschneiden (42A, 42B) zueinander auf beiden Oberflächen eine Verprägungszone (26) mit einem vorgegebenen Überprägungsoffset (O) erzeugt wird, welcher 1 bis 5% der Dicke des Einpresskontaktes (20) ausmacht, wobei das erste und zweite Teilwerkzeug (40A, 40B) während des Moldvorgangs in der Überprägungsposition verbleiben und den Kontaktierungsbereich (22) und den Raum (34) oberhalb und unterhalb der Einpressöffnung (24) von Moldmasse (30) freihalten, wobei die beiden Verprägungsschneiden (42A, 42B) jeweils eine Fläche einschließen, welche dem Kontaktierungsbereich (22) des Einpresskontaktes (20) entspricht.

5. Verfahren nach Anspruch 4, **dadurch gekennzeichnet, dass** die Teilwerkzeuge (40A, 40B) nach dem Aushärtungsvorgang der Moldmasse (30) wieder vom Einpresskontakt (20) abgehoben werden.

6. Moldwerkzeug (40) für die Moldumspritzung eines Moldmoduls (1), welches nach zumindest einem der Ansprüche 1 bis 3 ausgeführt ist, mit einer Kavität zur Aufnahme des zu umspritzenden elektronischen und/oder elektrischen Bauteils (3) und des mindestens einen am Modulrand angeordneten Einpresskontakts (20), wobei ein erstes Teilwerkzeug (42A) als Abdichtstempel mit einer umlaufenden ersten Verprägungsschneide (44A) ausgeführt ist, und ein zweites Teilwerkzeug (42B) als Abdichtstempel mit einer umlaufenden zweiten Verprägungsschneide (44B) ausgeführt ist, wobei die beiden Teilwerkzeuge (42A, 42B) relativbeweglich zueinander gelagert sind, wobei die Verprägungsschneiden (44A, 44B) einander gegenüberliegend angeordnet sind, wobei die Verprägungsschneiden (44A, 44B) der Teilwerkzeuge (42A, 42B) jeweils eine Fläche einschließen, welche dem Kontaktierungsbereich (22) des mindestens einen Einpresskontakts (20) entspricht.

7. Moldwerkzeug nach Anspruch 6, **dadurch gekennzeichnet, dass** die beiden Teilwerkzeuge (42A, 42B) bis zur Höhe der Verprägungsschneiden (44A, 44B) aufeinander zubewegbar ausgeführt sind.

## Claims

1. Moulded module (1) with at least one electronic and/or electrical component (3), which is enclosed by a moulding compound (30), and at least one press-in contact (20), which is arranged on the module edge and led out laterally from the moulded module (1) and which has an electrical contacting region (22) having a press-in opening (24) accessible from both surfaces, wherein the moulding compound (30) is deposited in the region of the at least one press-in contact (20) and respectively forms on both surfaces of the press-in contact (20) a moulded collar (32), which encloses the corresponding press-in contact (20) and absorbs press-in forces occurring in the event of contacting and respectively leaves a space (34) open above and below the corresponding press-in opening (24), wherein the press-in contact (20) has on both surfaces around the press-in opening (24) a stamping zone (26), which separates the electrical contacting region (22) from the moulding compound (30) and has an overstamping offset (O), which makes up 1 to 5% of the thickness of the press-in contact (20) .

2. Moulded module according to Claim 1, **characterized in that** the at least one press-in contact (20) is formed as a signal busbar (12, 12A, 12B) of a lead frame (10).

3. Moulded module according to Claim 2, **characterized in that** the signal busbar (12, 12A, 12B) connects an inner contact of the at least one electronic and/or electrical component (3) to a corresponding outer contact (14) designed as a press-in contact (20).

4. Method for producing an overmoulding of a moulded module (1), which is designed according to at least one of Claims 1 to 3, wherein, before a moulding operation, a first part-tool (40A) with a peripheral first stamping cutting edge (42A) is placed from above and a second part-tool (40B) with a peripheral second stamping cutting edge (42B) is placed from below on the surfaces of the at least one press-in contact (20) and a stamping zone (26) with a predetermined overstamping offset (O), which makes up 1 to 5% of the thickness of the press-in contact (20), is produced by a relative movement of the two stamping cutting edges (42A, 42B) in relation to one another on the two surfaces, wherein the first and second part-tools (40A, 40B) remain in the overstamping position during the moulding operation and keep the contacting region (22) and the space (34) above and below the press-in opening (24) free of moulding compound (30), wherein the two stamping cutting edges (42A, 42B) respectively enclose a surface area that corresponds to the contacting region (22) of the press-in contact (20).

5. Method according to Claim 4, **characterized in that**, after the operation of curing the moulding compound (30), the part-tools (40A, 40B) are lifted off again from the press-in contact (20).

6. Moulding tool (40) for the overmoulding of a moulded module (1), which is designed according to at least one of Claims 1 to 3, with a cavity for receiving the electronic and/or electrical component (3) to be overmoulded and the at least one press-in contact (20) arranged on the module edge, wherein a first part-tool (42A) is designed as a sealing die with a peripheral first stamping cutting edge (44A), and a second part-tool (42B) is designed as a sealing die with a peripheral second stamping cutting edge (44B), wherein the two part-tools (42A, 42B) are mounted relatively movably in relation to one another, wherein the stamping cutting edges (44A, 44B) of the part tools (42A, 42B) respectively enclose a surface area that corresponds to the contacting region (22) of the at least one press-in contact (20).

7. Moulding tool according to Claim 6, **characterized in that** the two part-tools (42A, 42B) are designed to be movable towards one another as far as the height of the stamping cutting edges (44A, 44B).

## Revendications

1. Module moulé (1) comprenant au moins un composant électronique et/ou électrique (3) qui est entouré d'un composé de moulage (30), et au moins un contact enfichable (20) qui est disposé sur le bord du module, qui est sorti latéralement du module de moule (1) et qui comporte une zone de contact électrique (22) pourvue d'une ouverture d'enfichage (24) accessible depuis les deux surfaces, le composé de moulage (30) étant déposé dans la région de l'au moins un contact enfichable (20) et formant sur chacune des deux surfaces du contact enfichable (20) un rebord moulé (32) qui entoure le contact enfichable (20) correspondant, qui absorbe des forces de pression se produisant pendant le contact et qui ménage un espace (34) au-dessus et au-dessous de l'ouverture d'enfichage correspondante (24), le contact enfichable (20) comportant sur les deux surfaces, autour de l'ouverture d'enfichage (24), une zone d'estampage (26) qui sépare la zone de contact électrique (22) du composé de moulage (30) et qui présente un décalage d'estampage (O) qui représente 1 à 5 % de l'épaisseur du contact enfichable (20).

2. Module moulé selon la revendication 1, **caractérisé en ce que** l'au moins un contact enfichable (20) est réalisé sous la forme d'un rail de signal (12, 12A, 12B) d'une grille emboutie (10).

3. Module moulé selon la revendication 2, **caractérisé en ce que** le rail de signal (12, 12A, 12B) relie un contact interne de l'au moins un composant électronique et/ou électrique (3) à un contact externe correspondant (14) réalisé sous la forme d'un contact enfichable (20) .

4. Procédé de réalisation d'un moulage par injection d'un module moulé (1), qui est conçu selon l'une au moins des revendications 1 à 3, une première partie d'outil (40A) pourvue d'une première lame d'estampage circonférentielle (42A) étant placée depuis le haut, et une deuxième partie d'outil (40B) pourvue d'une deuxième lame d'estampage circonférentielle (42B) étant placée depuis le bas, sur les surfaces de l'au moins un contact enfichable (20) avant un processus de moulage, et une zone d'estampage (26) étant générée avec un décalage d'estampage prédéterminé (O), qui représente 1 à 5 % de l'épaisseur du contact enfichable (20), par déplacement relatif des deux lames d'estampage (42A, 42B) l'une par rapport à l'autre sur les deux surfaces, les première et deuxième parties d'outil (40A, 40B) restant dans la position d'estampage pendant le processus de moulage et maintenant la zone de contact (22) et l'espace (34) au-dessus et au-dessous de l'ouverture de pression (24) sans composé de moulage (30), les deux lames d'estampage (42A, 42B) incluant chacune une surface qui correspond à la zone de contact (22) du contact enfichable (20).

5. Procédé selon la revendication 4, **caractérisé en ce que** les parties d'outil (40A, 40B) sont à nouveau soulevées du contact enfichable (20) après le processus de durcissement du composé de moulage (30).

6. Outil de moulage (40) destiné au moulage par injection d'un module moulé (1), qui est conçu selon l'une au moins des revendications 1 à 3, ledit outil de moulage comprenant une cavité destinée à recevoir le composant électronique et/ou électrique (3) à mouler et l'au moins un contact enfichable (20) disposé sur le bord du module, une première partie d'outil (42A) étant conçue comme un tampon d'étanchéité comprenant une première lame d'estampage circonférentielle (44A), et une deuxième partie d'outil (42B) étant conçue comme un tampon d'étanchéité comprenant une deuxième lame d'estampage circonférentielle (44B), les deux parties d'outil (42A, 42B) étant montées de manière à effectuer un déplacement relatif l'une par rapport à l'autre, les lames d'estampage (44A, 44B) étant disposées l'une en face de l'autre, les lames d'estampage (44A, 44B) des parties d'outil (42A, 42B) incluant chacune une surface qui correspond à la zone de contact (22) de l'au moins un contact enfichable (20).

7. Outil de moulage selon la revendication 6, **caractérisé en ce que** les deux parties d'outil (42A, 42B) sont conçues pour être déplaçables l'une vers l'autre jusqu'à la hauteur des lampes d'estampage (44A, 44B) .
